# EUROPÄISCHE PATENTSCHRIFT

(11) **EP 1 042 534 B1**
(45) Veröffentlichungstag und Bekanntmachung des Hinweises auf die Patenterteilung: **21.03.2007**
(21) Anmeldenummer: 98966331.5
(22) Anmeldetag: 15.12.1998
(51) Int. Cl.: C23F 11/16, C23F 11/14, B05D 3/10

(54) **BESCHICHTUNG VON METALLOBERFLÄCHEN INSBESONDERE FÜR DIE MIKROELEKTRONIK**
METAL SURFACE COATING, ESPECIALLY FOR MICRO ELECTRONICS
REVETEMENT DE SURFACES METALLIQUES NOTAMMENT POUR LA MICROELECTRONIQUE

(30) Priorität: 22.12.1997 DE 19757302
(43) Veröffentlichungstag der Anmeldung: 11.10.2000
(73) Patentinhaber: Infineon Technologies AG, 81669 München (DE)
(72) Erfinder: ATZESDORFER, Alexandra, D-79576 Weil am Rhein (DE); MÜLLER, Rainer, D-86529 Schrobenhausen (DE); HECKMANN, Klaus, D-93186 Pettendorf (DE); BAUER, Friederike, D-93049 Regensburg (DE)
(74) Vertreter: Schweiger, Martin
(86) Internationale Anmeldenummer: PCT/EP1998/008209
(87) Internationale Veröffentlichungsnummer: WO 1999/032688

(56) Entgegenhaltungen:
- EP-A- 0 529 373
- EP-A- 0 592 972
- EP-A- 0 598 361
- WO-A-90/05303
- DE-A- 2 342 256
- DE-A- 4 333 127
- FR-A- 2 236 018
- FR-A- 2 747 685
- GB-A- 1 038 176
- GB-A- 2 299 057
- US-A- 2 371 207
- US-A- 3 876 371
- US-A- 5 108 573
- GI XUE ET AL: "SURFACE REACTION OF 2-MERCAPTOBENZIMIDAZOLE ON METALS AND ITS APPLICATION IN ADHESION PROMOTION" JOURNAL OF THE CHEMICAL SOCIETY. FARADAY TRANSACTIONS, Bd. 87, Nr. 8, 21. April 1991, Seiten 1229-1232, XP000202378
- YUICHI YAMAMOTO ET AL: "SELF-ASSEMBLED LAYERS OF ALKANETHIOLS ON COPPER FOR PROTECTION AGAINST CORROSION" JOURNAL OF THE ELECTROCHEMICAL SOCIETY, Bd. 140, Nr. 2, 1. Februar 1993, Seiten 436-443, XP000378181
- PATENT ABSTRACTS OF JAPAN vol. 013, no. 423 (C-638), 20. September 1989 & JP 01 159386 A (SUMITOMO METAL MINING CO LTD), 22. Juni 1989
- PATENT ABSTRACTS OF JAPAN vol. 007, no. 046 (C-153), 23. Februar 1983 & JP 57 198269 A (FURUKAWA DENKI KOGYO KK), 4. Dezember 1982

## Beschreibung

Die Erfindung betrifft die Problematik der Haftungsverbesserung zwischen Metalloberflächen und darauf abgelagerten Polymeren wie beispielsweise Duroplasten. Gemäß einem weiteren Aspekt der Erfindung ist das Problem der Oxidation der Oberfläche von metallischen Körpern oder Partikeln betroffen.

Gerade bei der Herstellung von mit Gehäusen umhüllten Mikrochips ergibt sich aus einer mangelnden Haftung zwischen Metalloberflächen und Polymeren häufig das Problem der vorzeitigen Beschädigung des Mikrochips. Grund hierfür ist zum einen der Unterschied in den thermischen Ausdehnungskoeffizienten des zur Umhüllung verwendeten Polymers und des umhüllten Metalls. Bei thermischer Belastung entstehen an der Grenzfläche zwischen Polymer und Metall oft Mikrorisse, die bei weiterer Beanspruchung beispielsweise durch Feuchtigkeit zu Ausfällen führen können.

Bei einem Ausfall, der auf einen Effekt zurückzuführen ist, der "Popcorn"-Effekt genannt wird, ist Wasser durch das Gehäuse bis zum Metall-Leadframe des Chips diffundiert, wo es sich an einer Grenzfläche ansammelt. Bei einer Erwärmung des integrierten Bausteins beispielsweise bei einem Lötvorgang dehnt sich das an der Grenzschicht vorhandene Wasser aus, was bis zur Sprengung des Gehäuses führen kann.

Weiterhin ist problematisch, dass nicht alle in der Chipherstellung verwendeten Metalle mit den verfügbaren Polymeren umhüllt werden können. Bei einigen Stoffzusammenstellungen ergeben sich sogar grundsätzliche Haftungsprobleme.

Im Stand der Technik ist es zur Verbesserung der Haftung zwischen Polymeren und Metallen bekannt, einen Haftvermittler bzw. ein Primersystem zu verwenden. Diese Primer werden der zur Herstellung des Gehäuses verwendeten Pressmasse beigemischt. Trotz einer geringfügig verbesserten Haftung tritt bei diesen Gehäusen tritt der "Popcorn"-Effekt auf.

Nach X. H. Gu et. al. in "Applied Surface Science" 115, 66 (1997) wird 3-Aminopropyltriethoxysilan als Haftvermittler für Kupfer und Epoxidharz eingesetzt. Bei der Verwendung dieses Stoffs wird die Trockenhaftung des Epoxidharzes auf Kupfer erhöht. Unter Stressbedingungen insbesondere nach Feuchteauslagerung und unter dem Einfluss von hohen Temperaturen ergeben sich dennoch Haftungsprobleme.

Schließlich ist es bekannt, dass metallische Körper oder Partikel häufig einer Korrosion ausgesetzt sind, die deren Verarbeitung beispielsweise in einer metallischen Keramik behindern. Bei metallischen Körpern ist zudem eine Oxidation der Oberfläche unerwünscht.

Die EP 0 592 972 betrifft die Herstellung von Formen für mikromechanische Strukturen mittels Röntgenlithographie, wofür mit einem festhaftenden Resist beschichtete Substrate aus Metallen oder Halbleitern verwendet werden.

Die US 5 108 573 stellt eine elektrochemisch gebildete leitfähige Polymerschicht mit verbesserter Haftung und Gestalt auf Metallflächen bereit.

Die EP 0592 373 zeigt die Herstellung und Verwendung von Disulfiden für Edelmetalloberflächen.

Die WO 90/05303 betrifft eine Basis für einen Biosensor, wobei Hydrogel mittels einer monomolekularen Schicht an eine Metallschicht gebunden ist.

Die EP 0 598 361 stellt eine monomolekulare Schicht zur Verfügung, die dazu in der Lage ist, die Bildung eines dünnen Films in Gang zu setzen.

Es ist daher Aufgabe der Erfindung, Stoffe bereitzustellen, mit denen die Haftung von Polymeren auf Stoffen wie Metallen, beispielsweise Kupfer, auch unter ungünstigen Bedingungen verbessert wird. Weiterhin sollen Stoffe bereitgestellt werden, mit denen die Korrosion der Oberflächen von Partikeln und Körpern vermieden oder verringert werden kann. Der Erfindung liegt auch die Aufgabe zugrunde, die vorteilhafte Verwendung von Stoffen aufzuzeigen. Weiterhin sollen Verfahren zur Herstellung solcher Stoffe bereitgestellt werden. Das Bereitstellen gerade von entsprechend verbesserten Kunststoffverbundkörpern gehört ebenfalls zur Aufgabe der Erfindung.

Diese Aufgaben der Erfindung werden durch den Gegenstand der unabhängigen Hauptansprüche gelöst. Verbesserte Lösungen ergeben sich aus den jeweiligen Unteransprüchen.

Die Erfindung beruht auf dem Grundgedanken, einen Stoff zu verwenden, bei dem je ein Molekül in wenigstens eine erste Kopfgruppe sowie optional in wenigstens in eine zweite Kopfgruppe gegliedert ist, die über eine Spacergruppe miteinander in Verbindung stehen.

Durch diese funktionale Gliederung des erfindungsgemäßen Stoffs in eine oder mehrere Kopfgruppe und Spacergruppe kann besonders gut auf die Anforderungen, von mit einander zu verbindenden Polymeren und Stoffen wie Metallen bzw. dem Korrosionsschutz insbesondere von metallischen Körpern und Partikeln, Einfluss genommen werden.

Für den Fall, dass zwei Kopfgruppen vorgesehen sind, kann durch die Auswahl der geeigneten einen Kopfgruppe sichergestellt werden, dass die Kopfgruppe besonders reaktiv mit Polymermolekülen reagiert, wie sie für Polymere verwendet werden, die zur Umhüllung von Stoffen wie Metallen dienen. Die andere Kopfgruppe kann so ausgebildet sein, dass sie mit einer Oberfläche eines Stoffs eine haltbare Bindung eingeht, was auch besonders vorteilhaft ist, wenn eine metallische Oberfläche eines Partikels oder eines Körpers mit dem erfindungsgemäßen Stoff beschichtet werden soll. Bei der Verwirklichung der Erfindung wurde festgestellt, dass sich das im Stand der Technik bekannte 3-Aminopropyltriethoxysilan gemäß der Lehre der Erfindung als Haftvermittler zwischen Glas und Epoxidharz einsetzen lässt, jedoch nicht zwischen Metall und Epoxidharz.

Durch geeignete Ausbildung der Länge der Spacergruppe bzw. des Spacers, beispielsweise einer Kohlenwasserstoffkette, kann gewährleistet werden, dass der in einer Stoffschicht auf einer Stoffoberfläche abgelagerte Stoff hydrophobe Eigenschaften aufweist.

Die Länge des Spacers bestimmt dann gemäß dem Grundgedanken der Erfindung die Flexibilität und/oder die Wasserdurchlässigkeit der Schicht. Dadurch kann eine Feuchtigkeitssperre und somit ein Korrosionsschutz durch die Stoffschicht erreicht werden. Darüberhinaus verhindert das Vorsehen einer hydrophoben Schicht die lokale Ansammlung von Wassermolekülen, wodurch sich der "Popcorn"-Effekt wirksam vermeiden läßt.

Vorzugsweise wird ein Stoff eingesetzt, der in einer im wesentlichen monomolekularen Stoffschicht auf einer insbesondere metallischen Stoffoberfläche ablagerbar ist. Ein solcher Stoff kann über Chemisorption auf einer metallischen Oberfläche abgelagert werden, wobei der Stoff vorzugsweise in einem Lösungsmittel gelöst auf dem zu bedeckenden Körper abgelagert wird. Mit Chemisorption ist in diesem Fall gemeint, dass im Gegensatz zur Physisorption eine eher starke Bindung zwischen der Kopfgruppe und den oberflächenseitigen Atomen der metallischen Oberfläche besteht, vorzugsweise eine kovalente Bindung.

Durch die Verwendung optimierter Konzentrationen des Stoffs in dem Lösungsmittel scheiden sich self-assembled layers auf der Metalloberfläche ab, die je nach Prozessbedingungen als Monolayer ausgebildet sind. Diese dünnen Schichtsysteme sind chemisch und mechanisch besonders stabil und zeichnen sich durch eine sehr geringe Fehlstellendichte aus.

Bei dem erfindungsgemäßen Stoff kann auch die Spacergruppe so ausgebildet sein, dass sie mit den Polymermolekülen eines auf dem Metall abgelagerten Polymers besonders reaktiv reagiert. Dann wirkt der erfindungsgemäße Stoff als Haftverbesserungsmittel für Polymere auf der metallischen Oberfläche.

Darüber hinaus kann die Spacergruppe auch so ausgebildet sein, dass sie mit einer Spacergruppe eines anderen Moleküls eine Verbindung eingeht, wenn der Stoff als Schicht auf dem Metall abgelagert ist. Hierzu kann das Molekül auch eine dritte funktionelle Gruppe aufweisen, die mit der dritten funktionellen Gruppe eines weiteren Moleküls eine Verbindung eingeht. Dadurch wird gewährleistet, dass bei der Entwicklung von thermomechanischem Stress abgelöste Moleküle schnell wieder im Schichtverband einbinden. Dadurch bleibt auch nach dem Aufbringen von mechanischen Spannungen die gute Haftung des Polymers auf dem Metall erhalten. Eine solche Quervernetzung zwischen den einzelnen Molekülen kann bereits vor dem Aufbringen auf die Oberfläche hergestellt sein. Es ist aber auch möglich, die auf die Oberfläche aufgebrachten Moleküle nachträglich querzuvernetzen, beispielsweise durch die Bestrahlung mit UV-Licht.

Gemäß der Erfindung wird ein bifunktionelles Kupfer-Phthalocyanin mit hydrophobem Kettenteil, insbesondere mit ω-Hydroxyl- alkylaminen amidiertes Kupfer-[29H, 31H Phthalocyanin-2, 9or10, 16or17, 23or24 tetracarbonyltetrachlorid] als Haftverbesserungsmittel verwendet und diese wie im Anspruch 1 beansprucht wird.

Es zeichnete sich gerade mit ω-Hydroxylalkylaminen amidiertes Kupfer- [29H, 31H-Phthalozyanin-2,9 or 10,16 or 17,23 or 24-Tetracarbonyl Tetrachlorid] (Synthesevorschrift nach H. SHIRAI et.al., Makromol. Chemie 181, Seite 575 ff (1980), Amidierung analog zu Houben-Weyl Band VIII,-Seite 655 oder Band XI/2,S. 10 ff), aus. Mit diesen Stoffen ergibt sich eine besonders dauerhafte und haltbare Verbindung von Polymeren und Metallen wie Kupfer.

Die folgenden Hydroxylalkylamide :
Cu- [29H, 31H-Phthalocyanin-2,9or10, 16or17, 23or 24 Tetracarbonyltetra (11-hydroxylundecylamid)],
Cu- [29H, 31H-Phthalocyanin-2,9 or 10, 16 or 17, 23or 24 Tetracarbonyltetra (3-hydroxylpropylamid)],
Cu- [29H, 31H-Phthalocyanin-2,9 or 10, 16 or 17, 23or 24 Tetracarbonyltetra (6-hydroxylhexylamid)],
sind ebenfalls besonders vorteilhaft verwendbar, wobei diese jeweils unterschiedliche Kettenlängen der Spacergruppe aufweisen, nämlich C3, C6 oder C11. Durch eine geeignete Ausgestaltung der Länge der Spacergruppe wird sichergestellt, dass das verwendete Molekül sowohl ausreichend elastisch ist als auch ausreichend hydrophobe Eigenschaften aufweist. Durch diese Variation der Kettenlänge der Spacergruppe lässt sich eine Variation dieser Eigenschaften erzielen.

Vorteilhafterweise weist die metallseitige Kopfgruppe der erfindungsgemäßen Stoffe ein Kupfer Phthalocyanin auf, was eine zuverlässige Anbindung gewährleistet.

Bei dem erfindungsgemäßen Verfahren wird der erfindungsgemäße Stoff in einer 10⁻⁴-molaren Lösung in einem geeigneten organischen Lösungsmittel bereitgestellt. Das Lösungsmittel kann hierzu Aceton oder Ethanol aufweisen. Nach dem Eintauchen des Körpers in die Lösung für einen gewissen Zeitraum, beispielsweise 60 Sekunden, wird der Körper in einem Stickstoffstrom getrocknet. Vor dem Trocknen des Körpers kann auch das Spülen des Körpers in dem Lösungsmittel vorgesehen sein. Nach dem Aufbringen des Stoffs auf den Körper kann der Körper auch erwärmt werden, was die Haftung des Polymers auf dem Metall verbessert.

Die Erfindung umfasst auch einen Kunststoffverbundkörper, der einen Grundkörper aus einem Stoff wie metallischem Material sowie eine Beschichtung aus Polymermaterial wie insbesondere aus duroplastischem Material aufweist. Zur Haftungsverbesserung ist in dem Bereich zwischen Grundkörper und Beschichtung ein bifunktionelles Kupfer-Pthalocyanin mit hydrophobem Kettenteil vorgesehen, und zwar insbesondere in einer monomolekularen Schicht.

Die erfindungsgemäßen Kunststoffverbundkörper zeichnen sich insbesondere auch dadurch aus, dass bei einer Oberflächenuntersuchung einer insbesondere mit einem Scherversuch erzeugten Bruchfläche in einem Bereich zwischen Grundkörper insbesondere aus Metall und einer Beschichtung aus Polymer wie Epoxidharz mit einem elektronenspektroskopischen Verfahren eine charakteristische Verteilung von chemischen Elementen nachvollziehbar ist, die das Vorhandensein einer im wesentlichen monomolekularen Haftungsverbesserungsschicht aus einem bifunktionellen Kupfer-Pthalocyanin mit hydrophobem Kettenteil. Dabei ist gemäß der Erfindung von Bedeutung, dass auch mehrmolekulare Haftverbesserungsschichten einen erfindungsgemäßen Effekt ergeben können. Die elektronenspektroskopischen Verfahren werden zur Zeit mit ESCA (mit hoch energetischen Elektronen) mit XPS oder mit AES (mit Röntgenquanten) durchgeführt. Dabei wird die Absorption bzw. die Emission charakteristischer Strahlung detektiert, die durch den Beschuss bzw. durch das Bestrahlen erzeugt wird. Diese Strahlung lässt auf die Anwesenheit bestimmter Elemente schließen und bei der Integration über die Oberfläche kann die Elementzusammensetzung genau bestimmt werden. Anhand dieser zusammensetzung ergeben sich genaue Aufschlüsse über die Auftragungsart der Haftvermittlermoleküle, denn eine monomolekulare Schicht von organischen Molekülen hinterlässt in der Grenzfläche eine charakteristische Elementverteilung, die sich von der Elementverteilung deutlich unterscheidet, die sich ergibt, wenn die haftverbessernden Moleküle der Polymermasse in der Beschichtung beigemischt werden.

Einige ausgewählte Stoffe der erfindungsgemäßen Stoffe sind in der Zeichnung schematisch dargestellt.
- Figur 1: zeigt eine Vorstufe eines erfindungsgemäßen Stoffs, und
- Figur 2: zeigt einen ersten erfindungsgemäßen Stoff, der zum Einsatz als Haftverbesserungsmittel geeignet ist.

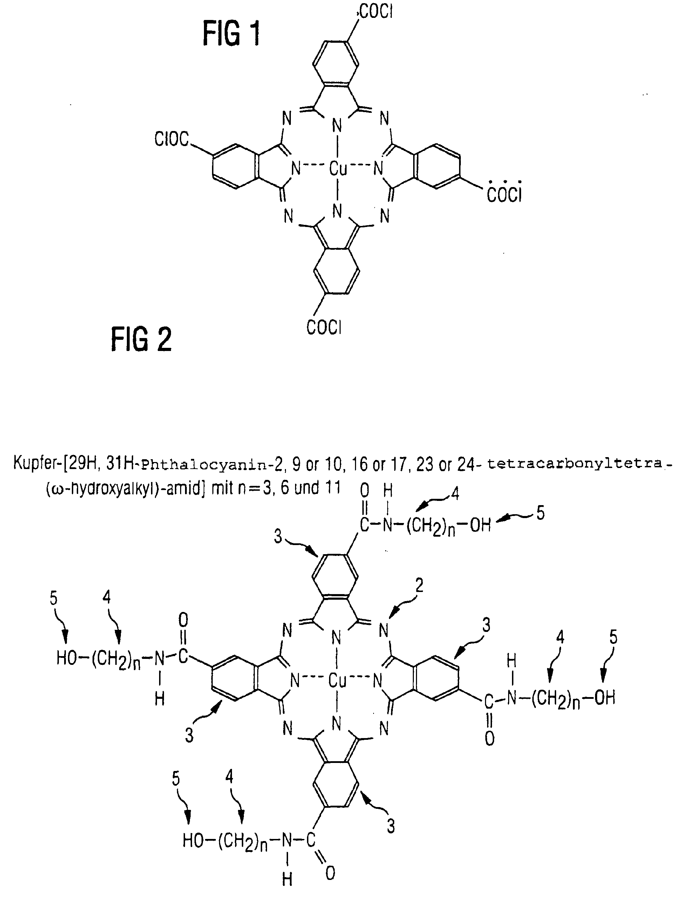

Figur 1 zeigt ein Kupfer- [29H, 31H-Phthalocyanin-2,9 or 10, 16 or 17, 23 or 24-Tetracalbonyltetrachlorid]-Molekül 1. Das Molekül 1 ist nach einer Synthesevorschrift gemäß H. SHIRAI et.al., makromologische Chemie 181, Seite 575 ff (1980), hergestellt.

Figur 2 zeigt das Molekül aus Figur 1 nach einer Amidierung mit ω-Hydroxylalkylaminen.

Der erfindungsgemäße Stoff 1 lagert sich in einer im wesentlichen monomolekularen Schicht auf einer Metalloberfläche ab. In der Mitte des erfindungsgemäßen Stoffs 1 ist Aminometall 2 gelegen, das durch ein komplexiertes Metall-Ion, vorzugsweise Cu²⁺, gebildet wird. Dabei bildet das Aminometall 2 eine erste Kopfgruppe, die über Benzolringe 3 mit der durch die ω- Hydroxyalykylamine gebildeten Spacergruppe 4 in Verbindung steht. An den Spacergruppen 4 vorgesehene OH-Gruppen bilden die polymerseitige Kopfgruppe 5.

Die Länge jeder der Spacergruppen 4 kann den Anforderungen angepasst werden. Insbesondere kann auch eine Spacergruppe verwendet werden, die eine weitere funktionale Gruppe beinhaltet, die mit derselben funktionalen Gruppe einer anderen Spacergruppe reaktiv in Verbindung treten kann.

Für die Spacergruppe kommen dafür insbesondere Kohlenstoff-Kohlenstoff-Doppelbindungen in Betracht.

Schließlich kann die zweite Kopfgruppe 5 durch andere Stoffe wie durch wenigstens eine Carbonsäuregruppe oder eine Aminogruppe bereitgestellt werden.

Solche Abwandlungen lassen sich synthetisch einfach erzeugen, wenn der Grundgedanke der Erfindung erkannt worden ist. Beispiele für solche abgewandelten Stoffe ist Phthalocyanin Kupfer- [29H, 31H-phthalocyanin-2,9 or 10,160r 17,23 or 2tetracarbonyl-tetra- (6-hexansaure)-amid.

## Patentansprüche

1. Verwendung der folgenden Substanz als haftverbessernde Schicht für einen mikroelektronischen integrierten Baustein mit einem Grundkörper aus metallischem Material sowie mit einer Umhüllung aus Polymermaterial, wobei die haftverbessernde Schicht zwischen dem metallischen Material und dem Polymer vorgesehen ist,:
ein bifunktionelles Kupfer-Phthalocyanin mit hydrophobem Kettenteil.

2. Verwendung nach Anspruch 1,
**dadurch gekennzeichnet, daß**
die Substanz Kupfer- [29H, 31H-Phthalocyanin-2, 9or10, 16or17, 23or24-tetracarbonyltetrachlorid], das mit [ω-Hydroxylalkylaminen amidiert ist oder Kupfer- [29H, 31H-Phthalocyanin-2, 9or10, 16or17, 23or24-tetracarbonyltetra-(6-hexansäure)-amid] aufweist.

3. Stoff, der insbesondere zur Verwendung gemäß Anspruch 1 oder Anspruch 2 bestimmt ist,
**dadurch gekennzeichnet, daß**
der Stoff Kupfer-[29H, 31H-Phthalocyanin-2, 9or10, 16or17, 23or24-Tetracarbonyltetra(11-hydroxylundecylamid)] und/oder Kupfer-[29H, 31H-Phthalocyanin-2, 9or10, 16or17, 23or24-Tetracarbonyltetra(3-hydroxylpropylamid)] und/oder
der Stoff Kupfer-[29H, 31H-Phthalocyanin-2, 9or10, 16or17, 23or24-Tetracarbonyltetra(6-hydroxylhexylamid)] aufweist.

4. Verfahren zur Herstellung des Stoffs nach Anspruch 3,
**dadurch gekennzeichnet, daß**
Kupfer-[29H, 31H-Phthalocyanin-2, 9or10, 16or17, 23or24-tetracarbonyltetrachlorid] mit ω-Hydroxylalkylaminen amidiert wird.

5. Mikroelektronisch integrierter Baustein, mit einem Grundkörper aus metallischem Material sowie mit einer Umhüllung aus Polymermaterial,
**dadurch gekennzeichnet, daß**
in einem Bereich zwischen Grundkörper und Umhüllung eine Schicht vorgesehen ist, wobei die Schicht ein bifunktionelles Kupfer-Phthalocyanin mit hydrophobem Kettenteil aufweist.

6. Mikroelektronisch integrierter Baustein nach Anspruch 5,
**dadurch gekennzeichnet, daß**
die Schicht ein mit ω-Hydroxylalkylaminen amidiertes Kupfer-[29H, 31H-Phthalocyanin-2, 9or10, 16or17, 23or24-tetracarbonyltetrachlorid] oder Kupfer- [29H, 31H-Phthalocyanin-2, 9or10, 16or17, 23or24-tetracarbonyltetra-(6-hexansäure)-amid] aufweist.

7. Mikroelektronisch integrierter Baustein nach Anspruch 5 oder Anspruch 6
**dadurch gekennzeichnet, daß**
die Schicht im wesentlichen monomolekular ist.

8. Mikroelektronisch integrierter Baustein nach einem der Ansprüche 5 bis 7,
**dadurch gekennzeichnet, daß**
das Polymermaterial der Umhüllung ein duroplastisches Material ist.

9. Verfahren zur Beschichtung eines Grundkörpers aus metallischem Material eines mikroelektronischen integrierten Baustein mit einer Schicht, die ein bifunktionelles Kupfer-Phthalocyanin mit hydrophobem Kettenteil aufweist, wobei das bifunktionelle Kupfer-Phthalocyanin mit hydrophobem Kettenteil in einer Lösung in einem organischen Lösungsmittel bereitgestellt wird und der Grundkörper in die Lösung eingetaucht wird.

10. Verfahren nach Anspruch 9,
**dadurch gekennzeichnet, dass**
nach dem Eintauchen des Grundkörpers in der Lösung der Grundkörper in einem Stickstoffstrom getrocknet wird.

11. Verfahren nach Anspruch 9 oder 10,
**dadurch gekennzeichnet, dass**
nach dem Aufbringen der Schicht der Grundkörper erwärmt wird.

## Claims

1. Use of the following substance as an adhesion-improving layer for a microelectronic integrated component having a base body of metallic material and also having a coating of polymer material, the adhesion-improving layer being provided between the metallic material and the polymer:
a bifunctional copper phthalocyanine having a hydrophobic chain part.

2. Use according to Claim 1, **characterized in that** the substance comprises copper [29H, 31H-phthalocyanine-2, 9or10, 16or17, 23or24-tetracarbonyl tetrachloride] amidated with ω-hydroxylalkylamines, or copper [29H, 31H-phthalocyanine-2, 9or10, 16or17, 23or24-tetracarbonyl tetra(6-hexanoic acid) amide.

3. Substance intended particularly for use according to Claim 1 or 2, **characterized in that** the substance comprises copper [29H, 31H-phthalocyanine-2, 9or10, 16or17, 23or24-tetracarbonyl tetra(11-hydroxylundecylamide)] and/or copper [29H, 31H-phthalocyanine-2, 9or10, 16or17, 23or24-tetracarbonyl tetra(3-hydroxylpropylamide)] and/or
the substance comprises copper [29H, 31H-phthalocyanine-2, 9 or 10, 16or17, 23or24-tetracarbonyl tetra(6-hydroxylhexylamide)].

4. Process for the preparation of the substance according to Claim 3, **characterized in that** copper [29H, 31H-phthalocyanine-2, 9or10, 16or17, 23or24-tetracarbonyl tetrachloride] is amidated with ω-hydroxylalkylamines.

5. Microelectronically integrated component, having a base body of metallic material and also having a coating of polymer material, **characterized in that** a layer is provided in a region between the base body and the coating, the layer comprising a bifunctional copper phthalocyanine having a hydrophobic chain part.

6. Microelectronically integrated component according to Claim 5, **characterized in that** the layer comprises an ω-hydroxylalkylamine-amidated copper [29H, 31H-phthalocyanine-2, 9or10, 16or17, 23or24-tetracarbonyl tetrachloride] or copper [29H, 31H-phthalocyanine-2, 9or10, 16or17, 23or24-tetracarbonyl tetra(6-hexanoic acid) amide.

7. Microelectronically integrated component according to Claim 5 or Claim 6, **characterized in that** the layer is essentially monomolecular.

8. Microelectronically integrated component according to any one of Claims 5 to 7, **characterized in that** the polymer material of the coating is a thermoset material.

9. Process for coating a base body of metallic material of a microelectronic integrated component with a layer comprising a bifunctional copper phthalocyanine having a hydrophobic chain part, which comprises providing the bifunctional copper phthalocyanine having a hydrophobic chain part in a solution in an organic solvent and dipping the base body into the solution.

10. Process according to Claim 9, **characterized in that** the base body is dried in a stream of nitrogen after it has been dipped in the solution.

11. Process according to Claim 9 or 10, **characterized in that** the base body is heated after the layer has been applied.

## Revendications

1. Utilisation de la substance constituée d'une phtalocyanine de cuivre bifonctionnelle dont une partie de la chaîne est hydrophobe comme couche d'amélioration de l'adhérence pour un composant microélectronique intégré qui présente un corps de base en un matériau métallique ainsi qu'une enveloppe en matériau polymère, la couche d'amélioration de l'adhérence étant prévue entre le matériau métallique et le polymère.

2. Utilisation selon la revendication 1, **caractérisée en ce que** la substance présente du cuivre-[29H, 31H-phtalocyanine-2, 9 ou 10, 16 ou 17, 23 ou 24-tétracarbonyltétrachlorure] amidé par des [ω-hydroxyalkylamines] ou du cuivre-[29H, 31H-phtalocyanine-2, 9 ou 10, 16 ou 17, 23 ou 24-tétracarbonyltétra-(acide 6-hexanoïque)-amide].

3. Substance destinée en particulier à être utilisée selon la revendication 1 ou la revendication 2, **caractérisée en ce que** la substance contient du cuivre-[29H, 31H-phtalocyanine-2, 9 ou 10, 16 ou 17, 23 ou 24-tétracarbonyltétra(11-hydroxyundécylamide)] et/ou du cuivre-[29H, 31H-phtalocyanine-2, 9 ou 10, 16 ou 17, 23 ou 24-tétracarbonyl(3-hydroxypropylamide)] et/ou **en ce que** la substance contient du cuivre-[29H, 31H-phtalocyanine-2, 9 ou 10, 16 ou 17, 23 ou 24-tétracarbonyl(6-hydroxyhexylamide)].

4. Procédé de préparation de la substance selon la revendication 3, **caractérisé en ce que** l'on amide par des ω-hydroxyalkylamines du cuivre-[29H, 31H-phtalocyanine-2, 9 ou 10, 16 ou 17, 23 ou 24-tétracarbonyltétrachlorure].

5. Module microélectronique intégré qui présente un corps de base en un matériau métallique ainsi qu'une enveloppe en un matériau polymère, **caractérisé en ce que** dans la zone située entre le corps de base et l'enveloppe est prévue une couche qui présente une phtalocyanine de cuivre bifonctionnelle dont une partie de la chaîne est hydrophobe.

6. Module microélectronique intégré selon la revendication 5, **caractérisé en ce que** la couche présente du cuivre-[29H, 31H-phtalocyanine-2, 9 ou 10, 16 ou 17, 23 ou 24-tétracarbonyltétrachlorure] ou du cuivre-[29H, 31H-phtalocyanine-2, 9 ou 10, 16 ou 17, 23 ou 24-tétracarbonyltétra-(acide 6-hexanoïque)-amide] amidés par ω-hydroxyalkylamines.

7. Module microélectronique intégré selon la revendication 5 ou la revendication 6, **caractérisé en ce que** la couche est essentiellement monomoléculaire.

8. Module microélectronique intégré selon l'une des revendications 5 à 7, **caractérisé en ce que** le matériau polymère de l'enveloppe est un matériau thermodurcissable.

9. Procédé de revêtement du corps de base en un matériau métallique d'un module microélectronique intégré par une couche qui présente une phtalocyanine de cuivre bifonctionnelle dont une partie de la chaîne est hydrophobe, la phtalocyanine de cuivre bifonctionnelle dont une partie de la chaîne est hydrophobe étant préparée en solution dans un solvant organique et le corps de base étant immergé dans la solution.

10. Procédé selon la revendication 9, **caractérisé en ce qu'**après l'immersion du corps de base dans la solution, le corps de base est séché dans un écoulement d'azote.

11. Procédé selon les revendications 9 ou 10, **caractérisé en ce qu'**après application de la couche, le corps de base est chauffé.
